# EUROPEAN PATENT SPECIFICATION

(11) **EP 1 223 584 B1**
(45) Date of publication and mention of the grant of the patent: **05.11.2008**
(21) Application number: 01205211.4
(22) Date of filing: 28.12.2001
(51) Int. Cl.: G11C 8/00

(54) **Memory device and method for handling out of range addresses**
Magnetischer Speicher und Anordnung zur Steuerung von Addressen ausserhalb des Bereichs
Dispositif de mémoire et méthode de commande d'adresses hors portée

(30) Priority: 29.12.2000 US 258773
(43) Date of publication of application: 17.07.2002
(73) Proprietor: Texas Instruments Incorporated, Dallas, Texas 75251 (US)
(72) Inventor: Spriggs, Stephen W., Rowlett, Texas 75089 (US); Jamison, George B., Murphy, Texas 75094 (US)
(74) Representative: Holt, Michael

(56) References cited:
- US-A- 5 287 321

## Description

### TECHNICAL FIELD OF THE INVENTION

The present invention relates in general to memory access technology and more particularly to a memory device and method for handling out of range addresses.

### BACKGROUND OF THE INVENTION

Many applications require memories which only use a subset of the available address decode combinations. This occurs when the number of possible address combinations is greater than the number of physical locations being addressed within and assigned to a single memory device. A conventional memory device includes an array of memory cells accessed by a row select signal. As long as a valid address is applied, a single row is selected and each bitline for the selected row is driven to a known state by the selected memory cells. However, if an out of range address is applied, none of the rows within the memory device are selected, causing the bitlines to be undriven and float to an unknown logic state. If provisions are not made within the memory device to handle an out of range address, problems such as high current and/or metastability will occur.

Previous efforts to solve the out of range address problem include using a weak feedback latch on each bitline. The weak feedback latch holds the existing logic value on the bitline and keeps it from floating when no row is selected. This approach has the disadvantage of slowing read access times since the feedback latch is always active even when the address is valid and in range. When a valid in range address is applied and a row is selected, the memory cells are forced to overdrive the weak feedback latch whenever the logic state of the bitlines are changed. This performance penalty increases as the supply voltage is lowered. In extreme cases, if the weak feedback latch is not carefully designed, functional failures may occur for those memory cells unable to force the weak feedback latch to transition from one logic level to another.

Another technique for solving the floating bitline problem for out of range addresses includes using a voltage or current differential sensing scheme. However, this scheme has no provision to guarantee the data read from invalid address locations. It is assumed that slight imbalances in the feedback of the sense amplifier used in such a scheme will eventually cause the bitline to resolve to either one logic level or the other after some period of time. While it is true that the sense amplifier will eventually resolve to a full logic state, excess power is consumed every time an out of range address condition occurs. The excess power consumption results from the metastable condition created when the sense amplifier is enabled with no differential voltage present on the bitlines.

Thus, conventional approaches to solving the floating bitline problem add to the access time when reading from and writing to a memory device and add to the power consumption of the memory device. Therefore, it is desirable to prevent a bitline from floating upon the occurrence of an out of range address that substantially improves the access time and power consumption of the memory device.

US 5,287,321 discloses a memory device according to the preamble of claim 1.

### SUMMARY OF THE INVENTION

The present invention provides apparatus as set forth in the claims.

### BRIEF DESCRIPTION OF THE DRAWINGS

For a more complete understanding of the present invention and the advantages thereof, reference is now made to the following description taken in conjunction with the accompanying drawing, wherein like reference numerals represent like parts, in which:

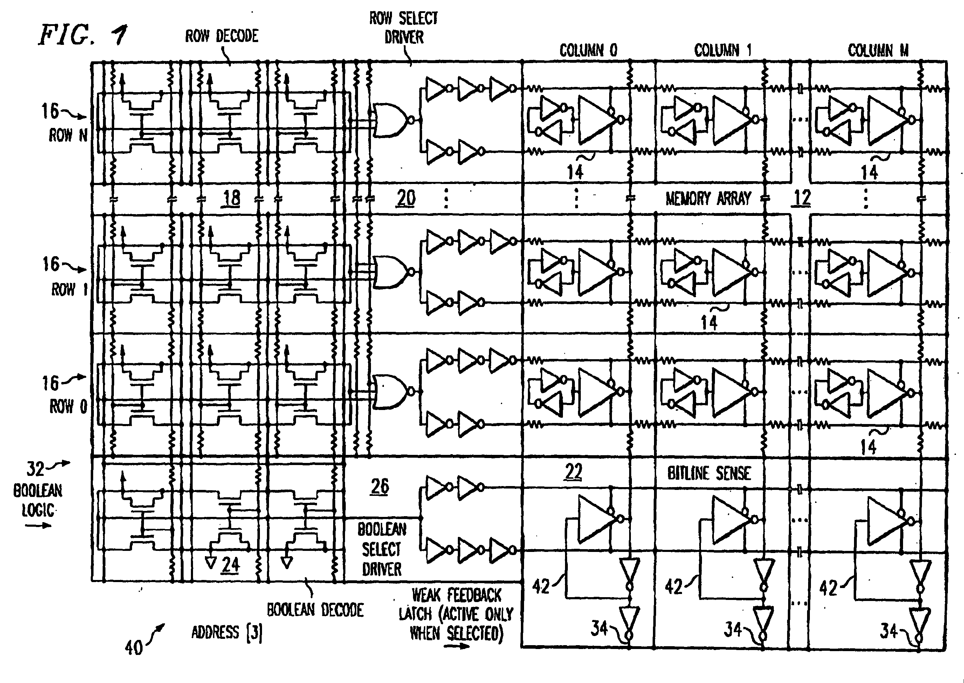

FIGURE 1 illustrates a memory device in accordance with an embodiment of the present invention.

### DETAILED DESCRIPTION OF THE INVENTION

FIGURE 1 is a diagram of a memory device 40. Memory device 40 includes a memory array 12 having a plurality of storage units 14 arranged in a plurality of rows 16. Memory device 40 includes a row decoder 18, a row selector 20, and a bitline sensor 22. Memory device 10 also includes an out of range decoder 24 and an out of range selector 26.

In normal operation, row decoder 18 receives address information and determines the appropriate row 16 corresponding to the received address information. The identified row 16 determined by row decoder 18 drives row selector 20 to enable storage units 14 associated with the identified row 16 to provide their outputs onto respective bitlines 34 for determination by bitline sensor 22.

In accordance with the present invention memory device 40 uses a feedback latch 42 on each bitline 34. Out of range decoder 24 identifies the occurrence of an out of range address and causes out of range selector 26 to enable feedback latches 42 on each bitline 34 of row 32. Feedback latches 42 hold the bitlines 34 at their previous state in order to provide outputs during an out of range address occurrence. Upon determination of a valid in range address, feedback latches 42 are disabled and the appropriate outputs from storage units 14 of the determined row 16 identified by row decoder 18 and row selector 20 may be placed onto respective bitlines 34.

## Claims

1. A memory device for handling out of range addresses, comprising: a memory array (12) having a plurality of storage units (14) arranged in a plurality of rows; a row decoder (18) operable to receive address information, the row decoder operable to determine which one of the plurality of rows of the memory array is to be accessed; a row selector (20) operable to select one of the plurality of rows determined by the row decoder in order to output values stored in its associated storage units onto respective bitlines; an out of range decoder (24) operable to receive address information, the out of range decoder operable to determine that none of the plurality of rows of the memory array is to be accessed for the received address information; a plurality of bitline drivers (22), one for each bitline; an out of range selector (26) operable in response to the out of range decoder, **characterized in that :**
each of the plurality of the bitline drivers (22) includes a feedback latch connected in a feedback loop (42) back to the bitline (34) and selected by said out of range selector (26).

2. The memory device of Claim 1, wherein:
the out of range selector (26) enables the feedback latch (42) of each of the plurality of the bitline drivers to maintain a previous value placed on the bitlines upon determining that the address information does not access any of the plurality of rows of the memory array.

3. The memory device of Claim 1 or Claim 2, wherein:
the out of range selector (26) disables the feedback latch (42) of each of the plurality of the bitline drivers upon determining that the address information accesses one of the plurality of rows of the memory array.

4. The memory device of any preceding claim, wherein:
the out of range decoder includes a boolean decoder operable to receive address information, the boolean decoder operable to determine that none of the plurality of rows of the memory array is to be accessed for the received address information; and
the out of range selector includes a boolean selector operable to select the bitline drivers in response to the boolean decoder determining that the received address information does not access any of the plurality of rows of the memory array.

## Patentansprüche

1. Ein Speichergerät zur Behandlung von Außerhalb-Bereichs-Adressen, enthaltend: eine Speicher-Matrix (12), die eine Mehrzahl von Speichereinheiten (14) besitzt, die in einer Mehrzahl von Reihen angeordnet sind; einen Reihen-Decoder, der fähig ist, Adress-Informationen zu empfangen, wobei der Reihen-Decoder fähig ist, festzustellen, auf welche Reihe aus der Mehrzahl von Reihen zugegriffen werden soll; einen Reihen-Selektor (20), der fähig ist, eine vom Reihen-Decoder bestimmte Reihe aus der Mehrzahl von Reihen auszuwählen, um Werte, die in deren zugeordneten Speichereinheiten gelagert sind, auf entsprechenden Bitleitungen auszugeben; einen Außerhalb-Bereichs-Decoder (24), der fähig ist, Adress-Informationen zu empfangen, wobei der Außerhalb-Bereichs-Decoder fähig ist, festzustellen, dass bei der empfangenen Adress-Information auf keine Reihe aus der Mehrzahl von Reihen aus der Speichermatrix zugegriffen werden soll; eine Mehrzahl von Bitleitungs-Treibern (22), einer pro Bitleitung; einen Außerhalb-Bereichs-Selektor (26), der dazu geeignet ist, auf den Reihen-Decoder anzusprechen, **dadurch gekennzeichnet, dass:**
jeder Bitleitungs-Treiber aus der Mehrzahl von Bitleitungs-Treibern (22) ein Rückkopplungs-Latch enthält, das in einer Rückkopplungs-Schleife (42) wieder mit der Bitleitung (34) verbunden ist und von genanntem Außerhalb-Bereichs-Selektor (26) gewählt wird.

2. Das Speichergerät aus Anspruch 1, in dem:
der Außerhalb-Bereichs-Selektor (26) es dem Rückkopplungs-Latch (42) jedes Bitleitungs-Treibers aus der Mehrzahl von Bitleitungs-Treibern ermöglicht, beim Feststellen, dass die Adress-Information keine Reihe aus der Mehrzahl von Reihen der Speicher-Matrix anspricht, einen vorhergehenden, auf den Bitleitungen liegenden Wert aufrecht zu erhalten.

3. Das Speichergerät aus Anspruch 1 oder Anspruch 2, in dem:
der Außerhalb-Bereichs-Selektor (26) das Rückkopplungs-Latch (42) jedes Bitleitungs-Treibers aus der Mehrzahl von Bitleitungs-Treibern deaktiviert beim Feststellen, dass die Adress-Information eine Reihe aus der Mehrzahl von Reihen der Speicher-Matrix anspricht.

4. Das Speichergerät nach jedem beliebigen vorstehenden Anspruch, in dem:
der Außerhalb-Bereichs-Decoder einen Binär-Decoder enthält, der fähig ist, Adress-Informationen zu empfangen, wobei der Binär-Decoder fähig ist, festzustellen, dass für die empfangene Adress-Information auf keine Reihe aus der Mehrzahl von Reihen der Speicher-Matrix zugegriffen werden soll; und
der Außerhalb-Bereichs-Selektor einen Binär-Selektor enthält, der fähig ist, die Bitleitungs-Treiber auszuwählen in Abhängigkeit des Binär-Decoders, der feststellt, dass die empfangene Adress-Information keine Reihe aus der Mehrzahl von Reihen der Speicher-Matrix anspricht.

## Revendications

1. Dispositif de mémoire pour gérer des adresses hors échelle, comprenant : une matrice mémoire (12) ayant une pluralité d'unités de stockage (14) disposées en une pluralité de rangées ; un décodeur de rangée (18) fonctionnel pour recevoir des informations d'adresse, le décodeur de rangée étant fonctionnel pour déterminer à laquelle de la pluralité de rangées de la matrice mémoire il convient d'accéder ; un sélecteur de rangée (20) fonctionnel pour sélectionner l'une de la pluralité de rangées déterminée par le décodeur de rangée afin de délivrer en sortie des valeurs stockées dans ses unités de stockage associées sur des lignes de bits respectives ; un décodeur hors échelle (24) fonctionnel pour recevoir des informations d'adresse, le décodeur hors échelle étant fonctionnel pour déterminer qu'il ne convient d'accéder à aucune de la pluralité de rangées de la matrice mémoire pour les informations d'adresse reçues ; une pluralité de circuits de commande de ligne de bits (22), un pour chaque ligne de bits ; un sélecteur hors échelle (26) fonctionnel en réponse au décodeur hors échelle, **caractérisé en ce que :**
chacun de la pluralité des circuits de commande de ligne de bits (22) inclut un verrou de rétroaction connecté dans une boucle de rétroaction (42) vers la ligne de bits (34) et sélectionné par ledit sélecteur hors échelle (26).

2. Dispositif de mémoire selon la revendication 1, dans lequel :
le sélecteur hors échelle (26) valide le verrou de rétroaction (42) de chacun de la pluralité des circuits de commande de ligne de bits pour conserver une valeur précédente placée sur les lignes de bits lors de la détermination que les informations d'adresses n'accèdent à aucune de la pluralité de rangées de la matrice mémoire.

3. Dispositif de mémoire selon la revendication 1 ou la revendication 2, dans lequel :
le sélecteur hors échelle (26) invalide le verrou de rétroaction (42) de chacun de la pluralité des circuits de commande de ligne de bits lors de la détermination que les informations d'adresses accèdent à l'une de la pluralité de rangées de la matrice mémoire.

4. Dispositif de mémoire selon l'une quelconque des revendications précédentes, dans lequel :
le décodeur hors échelle inclut un décodeur booléen fonctionnel pour recevoir des informations d'adresse, le décodeur booléen étant fonctionnel pour déterminer qu'il ne convient d'accéder à aucune de la pluralité de rangées de la matrice mémoire pour les informations d'adresse reçues ; et
le sélecteur hors échelle inclut un sélecteur booléen fonctionnel pour sélectionner les circuits de commande de ligne de bits en réponse à la détermination par le décodeur booléen que les informations d'adresse reçues n'accèdent à aucune de la pluralité de rangées de la matrice mémoire.
